# DEMANDE DE BREVET EUROPEEN

(11) **EP 0 664 567 A1**
(43) Date de publication de la demande: **26.07.1995**
(21) Numéro de dépôt: 95400106.1
(22) Date de dépôt: 19.01.1995
(51) Int. Cl.: H01L 29/812, H01L 21/338, H01L 29/08

(54) **Transistor de puissance microondes à double creusement, et son procédé de fabrication**

(30) Priorité: 25.01.1994 FR 9400769
(71) Demandeur: THOMSON-CSF SEMICONDUCTEURS SPECIFIQUES, 75008 Paris (FR)
(72) Inventeur: Pham Ngu, Tung, F-92402 Courbevoie Cédex (FR); Aubame, Evelyne, F-92402 Courbevoie Cédex (FR); Fellon, Philippe, F-92402 Courbevoie Cédex (FR); Decroix, Daniel, F-92402 Courbevoie Cédex (FR)
(74) Mandataire: Guérin, Michel

(57) **Abrégé**

L'invention concerne un transistor microondes, soumis à une tension drain-source élevée pour augmenter la puissance. Ce transistor comporte un double creusement ou "recess".

Selon l'invention, le recess de grille (24) est séparé du recess de drain (25) par une barrière (32) de longueur suffisante pour maintenir séparées les zones de charges d'espace (33,34) qui se développent sous les recess (24,25) lorsque la tension drain-source est proche de sa valeur maximale de tension de claquage.

Application aux circuits hyperfréquences de puissance.

## Description

La présente invention concerne un transistor de puissance microondes doté d'un double creusement entre source et drain. L'invention concerne également le procédé de réalisation de ce transistor, dont l'une des caractéristiques est que les deux creusements, dont l'un reçoit l'électrode de grille, sont côte à côte et séparés par une barrière.

Le transistor selon l'invention est du type à effet de champ, à structure horizontale, par opposition aux transistors à hétérojonction, bipolaires à structure verticale, qui eux aussi fonctionnent en micro-ondes. On sait que dans les transistors à effet de champ, les couches superficielles sont creusées entre la source et le drain, afin de rapprocher l'électrode de grille du canal, et ainsi d'abaisser la tension de seuil V_{T} : ce creusement est universellement désigné par le terme "recess", qui sera utilisé par la suite dans le but de simplifier les explications, et de différencier le creusement d'un fossé entre source et drain et le creusement d'un trou dans un masque de résine.

Le terme "transistor de puissance" est relatif, lorsqu'il s'agit des microondes: selon la fréquence envisagée, dans une gamme de 3 à 18 GHz par exemple, la puissance est de l'ordre de environ 1 à 5 W, donc faible par rapport à ce que l'on sait faire en silicium à basses fréquences. Et cependant, cette puissance diminue encore lorsque le transistor doit travailler à plus haute fréquence, entre 20 et 100 GHz par exemple. C'est pourquoi il est important, en microondes, d'augmenter la puissance, par exemple en augmentant la tension drain-source, à courant constant.

Les paramètres les plus importants dans les transistors de puissance considérés sont :
- Gₘ ou transconductance, exprimée en milliSiemens, qui assure un bon gain; elle est fonction inverse de la distance grille-source L_{gs}.
- V_{bds} ou tension de claquage (breakdown) entre drain et source (ds), qui permet d'augmenter la puissance; elle est inversement proportionnelle au carré de la distance "d" grille-drain.

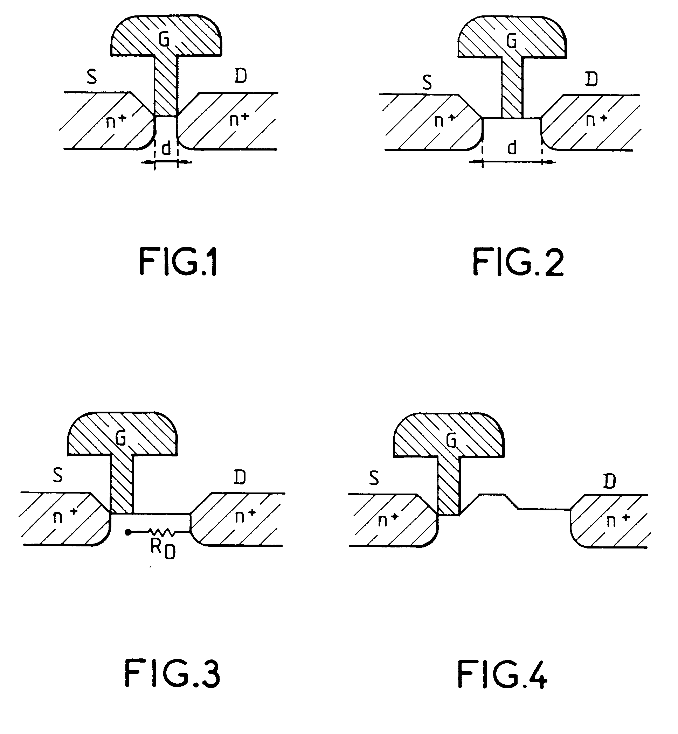

Du point de vue géométrique, les méthodes classiques de réalisation de transistors hyperfréquences avec grilles recess peuvent donner les structures schématisées par les figures 1 à 4, limitées à la région du pied de grille G située entre les deux caissons de prises de contacts de source S et de drain D :
- figure 1 : recess symétrique étroit, il est très proche de la longueur du pied de grille G. Caractéristiques : grande transconductance Gₘ, faible tension de claquage V_{bds}.
- figure 2 : recess symétrique large, pour augmenter V_{bds}, on augmente la distance "d" entre caissons n⁺, puisque V_{bds} est liée à 1/d², mais Gₘ diminue;
- figure 3: recess dissymétrique large. C'est une autre approche : le pied de grille est contre le caisson de source, d'où une grande transconductance Gₘ, et l'augmentation de la résistance de drain R_{D} donne une grande tension de claquage V_{bds}, mais il y a des difficultés technologiques, dues à la superposition de la grille dans la zone gravée.
- figure 4 : double recess. Outre le premier recess de pied de grille, symétrique étroit, il y a un second recess, séparé du premier, entre la grille et le drain. Cette géométrie permet d'obtenir des grilles champignons de faible résistance R_{g}. Le premier recess de pied de grille, étroit, engendre une grande transconductance Gₘ, et le second recess, qui est moins profond que le premier, augmente la résistance de drain R_{D}, et par voie de conséquence augmente V_{bds}.

Ce type de géométrie à double recess est décrit dans la demande de brevet français n° 9116377 du 31 décembre 1991, déposée par la demanderesse . En fait, la réalisation est délicate car il faut procéder avec un double masquage : creuser d'abord le premier recess de pied de grille puis le masquer et creuser le second recess. Or, si les multiples masquages sont courants, ce qui est difficile en l'espèce est de graver deux trous, dans deux masques, à deux moments distincts du procédé, lorsque ces deux trous sont distants d'environ 100 A° = 10 nm, ce qui est le cas en microondes.

De plus, si les deux recess sont séparés par une faible distance, les charges d'espace qui se développent sous les recess peuvent se toucher, ce qui revient à augmenter la longueur effective de grille, et donc à diminuer, la bande de fréquence de travail.

L'invention propose un transistor microondes de puissance muni d 'un double recess, mais qui comporte, situé entre les deux recess, une barrière de longueur suffisante pour empêcher les deux zones de charges d'espace de se toucher. En outre, le procédé de réalisation de cette structure comporte encore deux masquages, mais la gravure des deux recess est faite simultanément, parce qu'on sait faire deux trous dans un même masque avec plus de précision de positionnement que deux fois un trou dans deux masques différents.

De façon plus précise l'invention concerne un transistor de puissance microondes, comportant, supportées par un substrat, au moins deux couches semiconductrices dites active et de prise de contact, elles-mêmes gravées par deux creusements ou "recess" situés entre les métallisations de source et de drain du dit transistor, qui est caractérisé en ce qu'il comporte des moyens formant barrière entre les deux recess, la dite barrière étant de longueur supérieure à 100 nanomètres.

L'invention sera mieux comprise au moyen de la description qui suit d'un exemple de réalisation. Cette description s'appuie sur les figures jointes en annexe, qui représentent :
- figures 1 à 4 : quatre types de recess de grille, selon l'art connu, exposés précédemment,

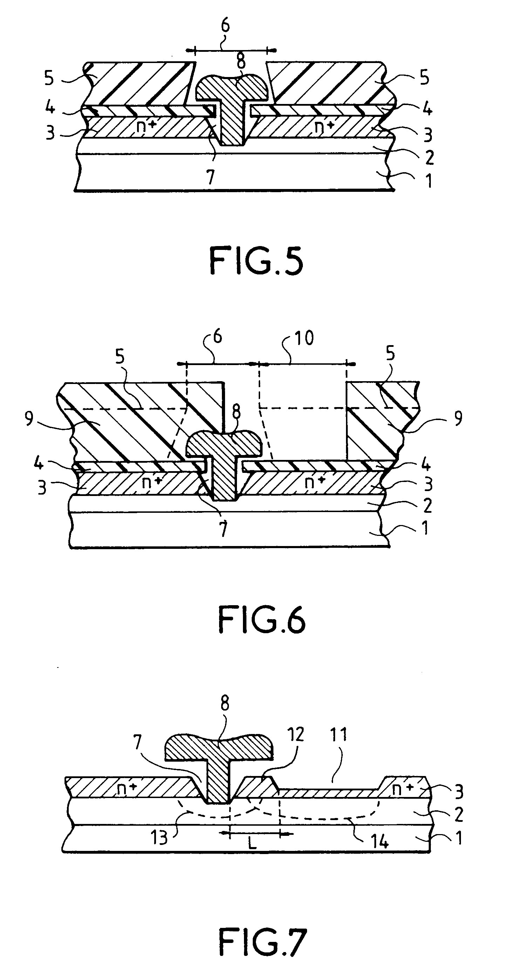

- figures 5 à 7 : trois étapes importantes de la réalisation d'un transistor à double recess, selon l'art connu,

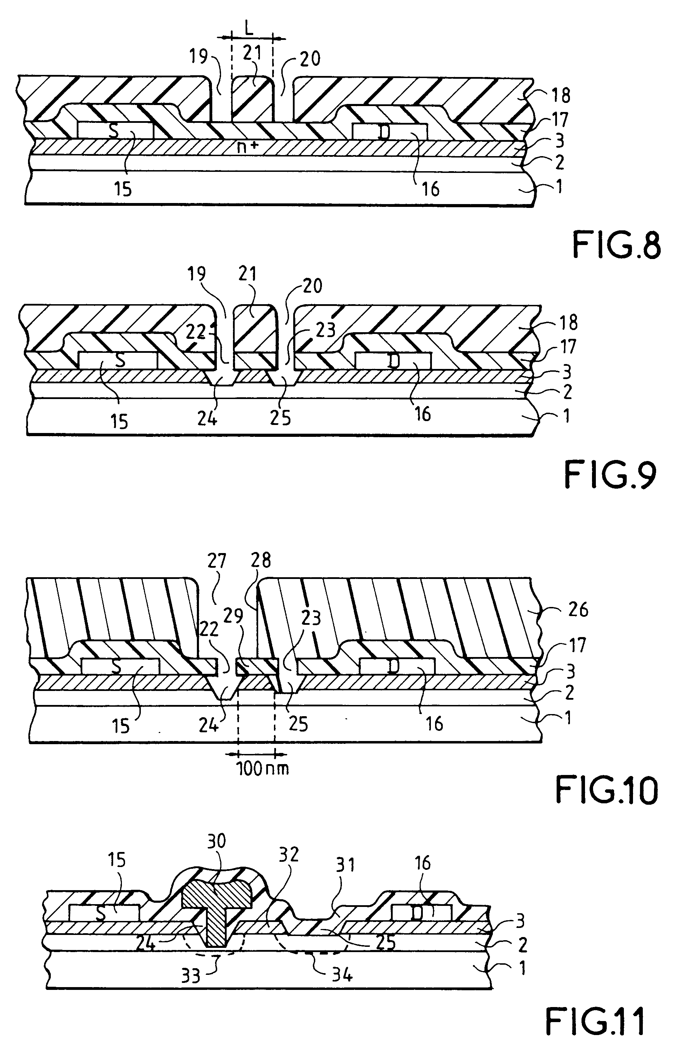

- figures 8 à 11 : étapes importantes de la réalisation d'un transistor selon l'invention.

Le rappel préliminaire de la structure et du procédé de réalisation d'un transistor de puissance microondes selon la demande de brevet précitée permettra de mieux comprendre les avantages de la structure et du procédé selon l'invention. Les figures 5 à 7 constituent un condensé de ce procédé.

La figure 5 montre l'étape du premier masquage, pour le premier recess de pied de grille. Sur une plaquette comportant un substrat 1 et au moins une couche active 2 et une couche 3 de prise de contact n⁺, on dépose un premier masque constitué d'une couche 4 de nitrure de silicium, par exemple et d'une couche 5 de résine. Au moyen d'une suite d'opérations de gravures qu'il n'est pas nécessaire de décrire ici, on grave une première ouverture 6 dans le premier masque, à l'emplacement de la future grille, puis on grave le premier recess 7 de pied de grille. On peut alors réaliser la grille en or 8.

Le premier masque 4+5 est dissous.

En figure 6, un second masque 9 de résine est déposé sur la face supérieure de la plaquette, puis on y grave une deuxième ouverture dont la partie utile 10 correspond un futur second recess de drain 11, qui peut alors être gravé - moins profondément que le premier recess de grille 7 -. Après retrait du second masque 9, la structure du transistor est celle qui est montrée en figure 7.

Le procédé et la structure qui en découle ont plusieurs inconvénients.

D'un point de vue technologique, on sait masquer des motifs de dimensions submicroniques, tels que les ouvertures 6 et 10, qui font environ 0.5µm = 500nm mais on ne sait pas bien positionner l'ouverture 10 par rapport à l'ouverture 6, dans deux masques différents, à deux époques du procédé.

Or il se fait que la partie 12 de la couche 3 dopée n⁺ qui est abritée par le champignon de la grille 8, et échappe ainsi à la gravure du recess de drain 11, fait environ 10 nm de longueur L, ce qui rend la précision de positionnement très aléatoire.

Ensuite, au cours de la gravure du second recess 11, le motif 12 n'est pas suffisamment long -dans le sens de la longueur L- et il y a des infiltrations des produits de gravure, qui viennent détruire le pied de la grille 8.

Enfin, les deux recess 7 et 11 développent chacun une zone d'espace de charge dans la couche active 2 : celles-ci sont représentées en pointillés 13 et 14. Ces zones sont d'autant plus importantes que la tension drain-source est élevée, pour augmenter la puissance du transistor. Selon la longueur L du motif 12, il arrive une valeur de tension, très proche de O volt, pour laquelle les deux zones de charges d'espace se recoupent, sous le motif 12, ce qui donne une pseudo-longueur de grille de valeur élevée : le transistor ne fonctionne plus aux fréquences supérieures, et, à cause du recoupement des deux zones de charges d'espace, la fréquence de coupure du transistor baisse lorsque la tension drain-source augmente pour accroître la puissance.

Le transistor selon l'invention, et le procédé correspondant, remédient à cet inconvénient en établissant entre les deux recess une barrière de longueur suffisante - supérieure à 100 nm par exemple- pour empêcher le recoupement des deux zônes de charges d'espace. La longueur de cette barrière est définie avec précision car les deux ouvertures correspondant aux deux recess sont faites simultanément.

Les figures 8 à 11 expliquent l'intérêt de cette nouvelle structure tout en exposant son procédé de réalisation.

Le produit de départ, en figure 8, est une tranche de matériaux semiconducteurs, comportant au moins un substrat 1, une couche active 2, une couche 3 dopée n⁺ de prise de contact, les métallisations 15 de source et 16 de drain et une couche 17 de nitrure de silicium, de 100 nm d'épaisseur.

Sur cette tranche, qui en est encore au stade de la fabrication collective, on dépose un premier masque de résine 18, dans lequel on grave deux ouvertures 19 et 20 à l'aplomb des deux futurs recess et en alignement entre source et drain. Ces deux ouvertures ont de l'ordre de 100 nm de largeur, et elles sont séparées par un motif 21 de 100 nm. La précision de gravure, en particulier du motif 21, est excellente parce que les deux ouvertures sont faites simultanément, dans une même couche de masquage : le problème est donc celui de la précision optique d'un seul masque, et non plus celui de la précision mécanique du positionnement d'un second masque par rapport à un premier masque.

Par des procédés connus de l'homme de l'art, la couche de nitrure 17, en figure 9, est gravée à travers les ouvertures 19 + 20 du masque de résine 18, et la gravure est poursuivie jusqu'à atteindre la couche active 2, sous la couche 3 de prise de contact n⁺. A la fin de la gravure, aux ouvertures 19 et 20 dans la résine correspondent, respectivement, les ouvertures 22 et 23 dans le nitrure et les recess 24 et 25 dans les couches 3 + 2 de matériaux semiconducteurs. Les deux gravures 24 et 25 ont la même profondeur, et elles affleurent la couche active 2.

Le premier masque de résine 18 est alors retiré.

Il est remplacé, en figure 10, par un second masque de résine 26 dans lequel on grave une ouverture 27 qui est centrée sur l'ouverture 22 dans le nitrure, du côté source du transistor. La largeur de l'ouverture 27 correspond à celle du champignon de grille qui sera réalisé ultérieurement. L'ouverture 23, côté drain du transistor, se trouve obturée par la résine du second masque 26, dont un bord 28, commun à la résine 26 et à l'ouverture 27, s'appuie sur le motif 29 de nitrure placé entre les deux ouvertures 22 et 23. Ceci est possible car le motif 29 a une longueur - dans le sens source-drain - de l'ordre de 100 nm ou plus, tandis qu'elle était de l'ordre de 10 nm dans l'exemple de l'art connu en figure 7.

En vue de régler la tension de seuil V_{T} du transistor, le recess de grille 24 est approfondi par une nouvelle gravure de la couche active 2. Au cours de cette gravure, le recess 25 n'évolue pas, puisqu'il est protégé par la résine 26.

Les opérations suivantes sont classiques et aboutissent au transistor représenté en figure 11. Elles consistent essentiellement à :
- déposer la métallisation de grille champignon 30,
- retirer le premier masque de nitrure 17 et le remplacer par un dépôt de passivation en nitrure 31,
- ouvrir les contacts sur les métallisations 15,16, et 30 à travers la passivation 31, et réaliser les interconnexions.

Le transistor réalisé est à double recess : il comporte un premier recess de grille 24, étroit, situé à proximité de la région de source, et un second recess 25, situé entre grille et drain, et dont la longueur et la profondeur de creusement dans les couches 3 et 2 déterminent la résistance de drain R_{D}. Ce second recess 25 agit en diviseur de tension entre drain et grille; il ne modifie pas la tension d'avalanche de la grille, mais augmente la tension de claquage entre source et drain, ce qui donne plus de puissance à ce transistor.

Mais la particularité de ce transistor tient dans la barrière 32 de matériau semi-conducteur qui sépare les deux recess 24 et 25. Cette barrière 32 a une longueur supérieure ou égale à 100nm, comme cela a déjà été dit, et cette longueur est précise car elle provient d'un seul masquage : elle est en tous cas adaptée en longueur pour que les zones de charges d'espace 33 sous le recess de grille 24 et 34 sous le recess de drain 25 ne se recoupent pas jusqu'à une tension proche de la tension d'avalanche V_{bds} augmentée de 1V, soit V_{DS} de l'ordre de 9 volts. Ainsi, ce transistor a une longueur de grille réelle - micronique ou submicronique pour les fréquences microondes - et non pas une pseudo-longueur de grille longue, comme dans l'art connu, parce que les deux zones de charges d'espace 33 et 34 ne modifient pas la longueur de grille : il n'y a plus de région hautement conductrice ininterrompue entre les deux caissons n⁺ de source et de drain. La longueur de la barrière 32 entre les deux recess 24 et 25 est calculée en fonction de la puissance visée pour ce transistor de puissance, et donc en fonction de la tension drain-source. Le transistor selon l'invention peut commander une plus grande puissance, parce que la barrière travaille en diviseur de tension, mais en outre, il peut encore délivrer de la puissance de zéro jusque 100 GHz, parce que les deux zônes de charge d'espace ne se recoupent pas.

Il est évident que les valeurs citées, notamment pour les dimensions des ouvertures ou des recess, ne limitent pas la portée de l'invention qui concerne un transistor de puissance microondes muni d'un double recess, et précisée par les revendications suivantes.

## Revendications

**1 -** Transistor de puissance microondes, comportant, supportées par un substrat (1), au moins deux couches semiconductrices dites active (2) et de prise de contact (3), elles-mêmes gravées par deux creusements ou "recess" (24,25) situés entre les métallisations de source (15) et de drain (16) du dit transistor, qui est caractérisé en ce qu'il comporte des moyens formant barrière (32) entre les deux recess (24,25), la dite barrière étant de longueur supérieure à 100 nanomètres.

**2 -** Transistor de puissance selon la revendication 1, caractérisé en ce que la barrière (32) est suffisamment longue pour que les zones de charge d'espace (33,34), qui se développent sous les recess (24,25), restent séparées jusqu'à une tension drain-source V_{DS} = 9 volts, dans la bande de 0 à 100 GHz.

**3 -** Transistor selon la revendication 2, caractérisé en ce que le premier recess (24), ou recess de grille, est de type symétrique étroit, situé plus près de la source (15) que du drain (16), et reçoit le pied de la métallisation de grille (30) du transistor.

**4 -** Transistor selon la revendication 2, caractérisé en ce que le second recess (25), ou recess de drain, est situé entre le drain (16) et le premier recess (24) et se comporte en diviseur de tension entre la grille (30) et le drain (16).

**5 -** Procédé de réalisation d'un transistor de puissance microondes à double recess (24,25), à partir d'une plaquette comportant un substrat (1) semiconducteur, au moins une couche active (2) et une couche de prise de contact (3) et les métallisations de source (15) et de drain (16), ce procédé étant caractérisé en ce qu'il comporte les étapes suivantes:
a) recouvrir la plaquette d'une première couche de nitrure de silicium (17) et d'une première couche de résine de masquage (18) et y graver, entre source et drain, deux ouvertures (19,20), aux emplacements des deux futurs recess, ces ouvertures étant séparées par un motif de résine (21) d'au moins 100 nanomètres de longueur (L),
b) opérer une première gravure de la couche de nitrure (22,23) et des couches semiconductrices (24,25), jusqu'à atteindre la couche active (2), ce qui forme le second recess, ou recess de drain (25),
c) ôter la première couche de résine (18), la remplacer par une deuxième couche de résine (26) et y graver une ouverture (27) centrée sur le recess de grille (24), le second recess (25) étant masqué par la résine (26),
d) opérer une deuxième gravure de la couche active (2), afin d'approfondir le recess de grille (24) à la valeur commandée par la tension de seuil V_{T} recherchée,
e) déposer la métallisation, de grille (30), puis ôter la deuxième couche de résine (26) et la première couche de nitrure (17), la remplacer par une seconde couche de nitrure (31), la graver à l'aplomb des métallisations d'électrudes (15,16,30) et déposer la métallisation d'interconnexions.
